# EUROPÄISCHE PATENTSCHRIFT

(11) **EP 0 494 673 B1**
(45) Veröffentlichungstag und Bekanntmachung des Hinweises auf die Patenterteilung: **30.08.1995**
(21) Anmeldenummer: 92100286.1
(22) Anmeldetag: 09.01.1992
(51) Int. Cl.: B65G 59/02, B65G 51/03, H01L 21/00

(54) **Vorrichtung und Verfahren zum automatischen Vereinzeln von gestapelten Scheiben**
Device for and methods of automatically separating stacked discs
Dispositif et procédés pour séparer automatiquement des disques empilés

(30) Priorität: 10.01.1991 DE 4100526
(43) Veröffentlichungstag der Anmeldung: 15.07.1992
(73) Patentinhaber: Wacker-Siltronic Gesellschaft für Halbleitermaterialien mbH, D-84489 Burghausen (DE)
(72) Erfinder: Frank, Walter, D-84508 Burgkirchen (DE); Pemwieser, Albert, A-5211 Ach (AT); Spatzier, Gerhard, A-5142 Eggelsberg 108 (AT)
(74) Vertreter: Rimböck, Karl-Heinz, Dr.

(56) Entgegenhaltungen:
- WO-A-85/05758
- IBM TECHNICAL DISCLOSURE BULLETIN. Bd. 17, Nr. 9, Februar 1975, NEW YORK US, S. 2703 - 2704; T. J. RAJAC: 'Article transfer / cleaning / inspection station'

## Beschreibung

Die Erfindung betrifft eine Vorrichtung zum Vereinzeln von scheibenförmigen Werkstücken, insbesondere Halbleiterscheiben, von einem Scheibenstapel. Sie betrifft ferner ein Verfahren zum Vereinzeln von scheibenförmigen Werkstücken.

Die Herstellung von einkristallinen oder polykristallinen Halbleiterscheiben, beispielsweise aus Silicium oder aus Verbindungshalbleitern wie Galliumarsenid oder Indiumphosphid, erfordert das Sägen stab- oder blockförmiger ein- oder polykristalliner Werkstücke. Insbesondere kommen dabei Drahtgattersägen zum Einsatz, mit welchen in einem Sägevorgang bis zu mehrere hundert dünne ein- oder polykristalline Scheiben gleichzeitig von einem Stab oder Block des Halbleitermaterials abgetrennt werden. Es liegt dann nach dem Sägevorgang ein gegebenenfalls durch Sägestaub und Sägeflüssigkeit verunreinigter Stapel dieser dünnen Scheiben vor, die dann einzeln abgenommen und zur weiteren Bearbeitung in einen Warenträger (Scheibenmagazin, Horde) eingebracht werden müssen. Diese Arbeit wird üblicherweise von Hand ausgeführt.

In ähnlicher Weise in gestapelter Form vorliegende Scheibenkollektive fallen beim Sägen einkristalliner Werkstücke, z.B. Stäbe, zu Scheiben an und können auch in weiteren Phasen des Bearbeitungsprozesses, z. B. bei Läpp-, Ätz- oder Polierschritten, auftreten. Im Stapel können die Scheiben in im wesentlichen sauberer oder beträchtlich, beispielsweise durch Sägestaub, Abrieb oder Öl, verunreinigter Form vorliegen.

Die Vereinzelung der Scheiben ist notwendig, um beispielsweise eine weitere Bearbeitung der Oberfläche durchführen zu können. Solche Bearbeitungsvorgänge können nur vollständig und sauber durchgeführt werden, wenn beide Oberflächen für das Bearbeitungsmittel, beispielsweise Lösungen zum Reinigen, Beschichten oder Ätzen, Werkzeuge zum Polieren oder Läppen oder Gase zur Reaktion mit der Oberfläche, gut zugänglich sind. Dazu werden die einzelnen Scheiben beispielsweise in Prozeßhorden eingeführt.

Insbesondere, wenn die Scheiben eine geringe Dicke von zumeist nur bis zu ca. 200 »m und damit eine große Zerbrechlichkeit aufweisen, ist die Vereinzelung von Hand eine sehr diffizile und unangenehme Arbeit. Die geringe mechanische Beständigkeit der Scheiben führt zu Verlusten durch Bruch. Da für Halbleitermaterial extrem hohe Anforderungen an die Reinheit und Fehlerlosigkeit der Oberfläche gestellt werden, ist die Ausführung dieser Arbeit von Hand zudem ein Grund für Verschmutzungen und Beschädigungen, z. B. durch Kratzer, der vermieden werden sollte.

Versuche zur Automatisierung waren bisher nicht erfolgreich. So scheitert ein Abnehmen der Scheiben vom Stapel mit mechanischen Mitteln (wie etwa Vakuumsaugern) an den Adhäsionskräften zwischen den Scheiben, die häufig Bruchverluste hervorrufen. Darüberhinaus ist eine mechanische Berührung der Scheibe nötig, die zu Verunreinigungen und Fehlern auf der Scheibenoberfläche führt.

Verschmutzungen der oben beschriebenen Art auf der Scheibenoberfläche, z. B. durch Sägestaub, Abrieb oder Öl, stellen ein weiteres Problem dar, mit dem die bisherigen Systeme nicht fertig wurden. So führen Verschmutzungen bei getrockneten Scheiben zum Verkleben und damit auftretenden Schwierigkeiten beim Vereinzeln, feuchte oder klebrige und mit festen Bestandteilen verschmutzte Scheiben führen zur Unsauberkeit und damit Unzuverlässigkeit des Vereinzelungsgeräts. In allen Fällen ist bei verschmutzten Scheiben die Wahrscheinlichkeit von Beschädigungen größer. Darüberhinaus bestand die Meinung, daß die Adhäsionskräfte zwischen den Scheiben zu stark sind, um eine automatische Trennung durchzuführen, nachdem diese Kräfte für manche Prozesse, etwa das Bonden, sogar ausgenützt werden können.

Aus der Patentanmeldung WO-85/05758 A1 ist eine Vorrichtung bekannt, mit deren Hilfe in Transporthorden gestapelte Halbleiterscheiben in einer abgeschlossenen Gasatmosphäre durch die Wirkung eines gasförmigen Mediums in ein Tunnel transportiert und behandelt werden können.

Im IBM Technical Disclosure Bulletin Vol. 17, No.9, February 1975, Seite 2703-2704 ist eine geschlossene Vorrichtung offenbart, die es ermöglicht, Halbleiterscheiben mit Hilfe eines Gasstroms aus einer ersten Transporthorde zu einer Meß- und Reinigungsstelle und danach in eine zweite Transporthorde zu transportieren.

Die Aufgabe der vorliegenden Erfindung lag darin, eine Vorrichtung zum Vereinzeln gestapelter Scheiben anzugeben, die die genannten Nachteile vermeidet und insbesondere ein automatisches Abheben der Scheiben vom Scheibenstapel ohne mechanische Berührung sowie gegebenenfalls den Transport der vereinzelten Scheiben zu einem Scheibenmagazin (Horde) und die schonende Einbringung in die Horde gestattet. Dabei soll gegebenenfalls auch eine erste Reinigung der mit Rückständen des Sägevorgangs behafteten Scheiben erfolgen. Die Aufgabe lag ferner darin, ein entsprechend gestaltetes, derartige Schritte beinhaltendes Verfahren anzugeben.

Gelöst wird die Aufgabe durch eine Vorrichtung zum Vereinzeln von scheibenförmigen Werkstücken, insbesondere Halbleiterscheiben, von einem Scheibenstapel, die gekennzeichnet ist durch
a) ein Scheibenmagazin (2) zur Aufnahme eines Scheibenstapels (1), in dem benachbarte Scheiben berührend aufeinanderliegen, mit einer Vorschubeinheit (3), die die oberste Scheibe (4) des Scheibenstapels in den Wirkungsbereich eines fluiden Mediums (11) bringt
b) ein Düsensystem (5), durch das das fluide Medium in einer Vorzugsrichtung unter Druck austritt
c) ein Wehr (8), das es erlaubt, genau eine Scheibe aus dem Scheibenstapel (1) zu vereinzeln.

Ferner wird die Aufgabe durch ein Verfahren gelöst, das dadurch gekennzeichnet ist, daß scheibenförmige Werkstücke von einem Scheibenstapel, in dem benachbarte Scheiben berührend aufeinanderliegen, unter Verwendung der Vorrichtung durch die Einwirkung eines aus Düsen strömenden fluiden Mediums vereinzelt werden.

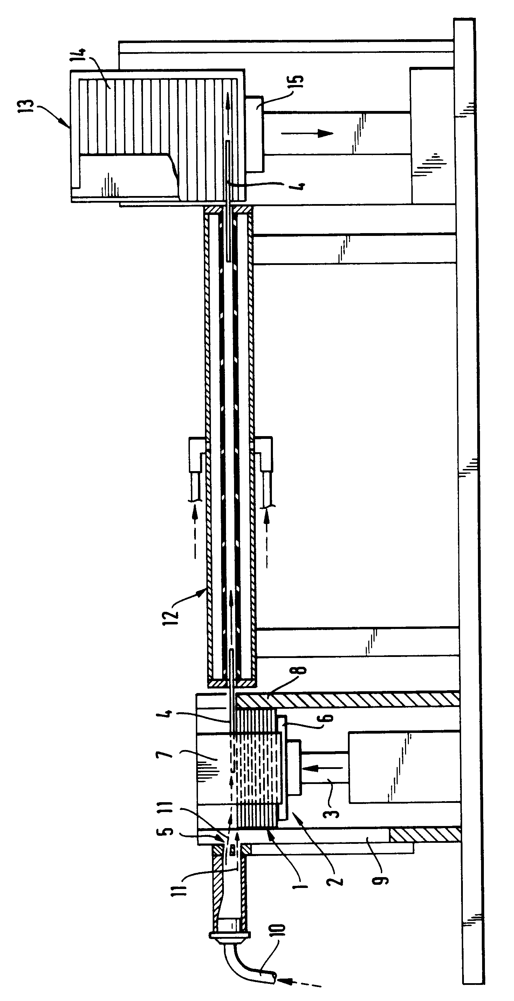

Im folgenden wird die Erfindung anhand der Figur 1 näher erläutert. Fig.1 zeigt eine mögliche Ausführungsform der Vorrichtung, bei der die vereinzelten Scheiben zusätzlich über eine Transportvorrichtung in eine Einhordvorrichtung übergeführt werden. Selbstverständlich ist diese mögliche Ausführungsform nicht im Sinne einer Beschränkung des Erfindungsgedankens zu verstehen.

Bei der dargestellten Anordnung wird ein Stapel 1 aus den zu vereinzelnden scheibenförmigen Werkstücken, der im Scheibenmagazin 2 ruht, das durch die Vorschubeinheit 3 bewegt wird, vereinzelt. Es können beispielsweise scheibenförmige Werkstücke aus Halbleitermaterialien wie Silicium, Galliumarsenid oder Indiumphosphid, aber auch von Scheiben aus oxidischem Material wie Gallium-Gadolinium Granat, ferritischem Material, Saphir, Spinell oder Glaswerkstoffen und Quarz vereinzelt werden. Möglich ist jedoch allgemein die Vereinzelung von scheibenförmigen Werkstücken auch beispielsweise aus Kunststoffen oder Metallen. Solche Stapel von Scheiben fallen insbesondere beim Zersägen von stab- und blockförmigen Werkstücken von monokristallinem Material, wie es beispielsweise bei Tiegelziehverfahren nach Czochralski oder beim tiegelfreien Zonenziehen entsteht, oder multikristallinem Material, wie es beispielsweise aus Silicium für die Solarzellenproduktion hergestellt wird, mittels multiplen Trennverfahren, z. B. Drahtgattersägen, an. Dieses Material ist dann in der Regel noch mit den Rückständen des Sägevorgangs, etwa Sägestaub aus dem gesägten Material und Sägemittel wie zum Beispiel Ölen mit kristallinen Beimengungen verunreinigt. Die Erfindung eignet sich weiterhin zum Vereinzeln von gestapelten Scheiben in anderen Stadien des Herstellungsprozesses, z. B. gereinigten oder auch nachbehandelten oder polierten Scheiben. Die Scheiben können im Stapel trocken oder naß vorliegen, vorteilhaft ist jedoch die Vereinzelung nicht vollständig trockener Scheiben, insbesondere dann, wenn sie nicht gereinigt sind, da es sonst zum Verkleben der Scheiben kommen kann.

Durch die Erfindung können Scheiben unabhängig von ihrer Dicke vereinzelt werden. In der Halbleitertechnologie sind Scheibendicken von 100 bis 1000 »m üblich, jedoch ist auch noch die Vereinzelung demgegenüber dünnerer oder dickerer Scheiben möglich. Vorteilhaft lassen sich insbesondere sehr dünne Scheiben, im unteren Dickenbereich von bis zu 200 »m, vereinzeln. Neben Scheibenstapeln, die aus einzelnen Scheiben bestehen, können auch solche aus miteinander verbundenen, beispielsweise verklebten oder gebondeten Scheiben, vereinzelt werden, ohne daß die Bondung oder Verklebung gelöst wird.

Der Scheibenstapel 1 wird in ein Scheibenmagazin 2 eingebracht, das mit einer Vorschubeinheit 3 versehen ist, um die oberste Scheibe 4 in den Bereich des Vereinzelungsdüsensystems 5 zu bringen. Der Scheibenstapel kann dabei direkt auf dem Stempel 6 der Vorschubeinheit 3 aufliegen, die Führung des Stapels erfolgt dann durch die Seitenplatten 7 und das Wehr 8. In dieser Ausführungsform bewegen sich die Scheiben somit relativ zu den Seitenplatten aufwärts.

In einer anderen möglichen Ausführungsform werden die Scheibenstapel jedoch in einen Behälter eingebracht, der dann in das Scheibenmagazin der Vereinzelungsvorrichtung eingesetzt wird und auf dem Stempel der Vorschubeinheit ruht. Dieser Scheibenbehälter besitzt Seitenwände zur Führung und Halterung der Scheiben, ist zum Wehr hin offen und besitzt auf der Rückseite eine Öffnung oder Schlitze, durch die das fluide Medium, das aus den Düsen strömt, auf die Scheiben einwirken kann. In dieser Ausführungsform bewegen sich die Scheiben nicht relativ zu den Seitenwänden des Behälters, sondern die Seitenwände des Behälters bewegen sich relativ zu den Seitenplatten des Scheibenmagazins. Dies hat den Vorteil, daß ein seitliches Anstoßen und Verkanten der Scheiben vermieden und der Scheibenbehälter der Größe und Form der Scheiben angepaßt werden kann, so daß bezüglich der Form und Größe unterschiedliche Scheiben mit der gleichen Vereinzelungsvorrichtung vereinzelt werden können. Vorteilhaft besitzt der Behälter am Boden eine passgenau zum Stempel ausgeführte Führungseinheit, beispielsweise einen Zapfen, der sich in ein entsprechendes Gegenstück, beispielsweise eine entsprechende Bohrung des Stempels einfügt, um ein Verrutschen des Behälters zum Beispiel zur Seite zu verhindern.

Die Scheibenform ist bei den zu vereinzelnden Scheiben keiner Beschränkung unterworfen; die Erfindung eignet sich sowohl für die üblicherweise in der Halbleitertechnologie verwendeten näherungsweise bzw. runden, als auch die in der Solartechnologie üblichen viereckigen oder quadratischen Scheiben. Es lassen sich sogar Scheiben von polygonalen und anderen Querschnitten vereinzeln.

Die Scheibenform beeinflußt die Formgebung des Scheibenmagazins nicht, so daß grundsätzlich aus einem rechteckigen Scheibenmagazin beispielsweise auch runde oder polygonale als Stapel vorliegende Scheiben vereinzelt werden können. Es ist jedoch vorteilhaft, wenn die Scheiben von den Wänden des Magazins möglichst eng, insbesondere in einem Toleranzbereich von etwa 0.5 - 10 mm, umschlossen werden. Die Dimensionierung des Scheibenmagazins ist von der Scheibengröße abhängig. Sie ist beliebig wählbar, wobei bei den in der Halbleitertechnologie üblichen runden Scheiben in der Regel ein Durchmesser von 50 bis 300 mm üblich ist. Bei rechteckigen, insbesondere quadratischen Scheiben sind ähnliche Kantenlängen üblich.

Wenn Scheiben unterschiedlicher Größe und Durchmessers mit ein und derselben Vorrichtung vereinzelt werden sollen, wird vorteilhaft die Rückwand 9 des Scheibenmagazins 1, in der sich das Vereinzelungsdüsensystem 5 befindet, in Austrittsrichtung der Scheiben verschiebbar zum Wehr 8 angeordnet. In der Ausführungsform, in der der Scheibenstapel direkt auf dem Stempel 6 der Vorschubeinheit 3 ruht, werden vorteilhaft in diesem Fall auch die Seitenplatten 7 und der Stempel 6 auswechselbar oder verstellbar ausgeführt. Dies ist nicht nötig in der Ausführungsform, in der die Scheiben in einem Behälter in das Scheibenmagazin der Vereinzelungsvorrichtung eingebracht werden.

Das Scheibenmagazin ist mit einer Vorschubeinheit 3 ausgestattet, die es erlaubt, die jeweils oberste Scheibe 4 in den Bereich des Vereinzelungsdüsensystems 5 zu bringen. Die Vorschubeinheit bewegt zu diesem Zweck z. B. einen Stempel 6, der aus einer ebenen, der Form des Scheibenmagazins angepaßten Platte besteht, nach oben, wobei auf dem Stempel die Scheibenhalterung oder der Scheibenstapel selbst ruhen. Im Prinzip kann der Vorschub des Scheibenmagazins von Hand erfolgen, vorteilhaft ist jedoch eine Ausführungsform, in der die Vorschubeinheit mechanisch, beispielsweise pneumatisch oder durch einen Motor, beispielsweise Elektromotor in Richtung des Vereinzelungsdüsensystems 5 bewegt wird. Als Motor kann ein Gleichstrommotor dienen, der das Magazin mit konstanter Geschwindigkeit bewegt. Vorteilhaft ist die Verwendung eines Schrittmotors, der das Magazin schrittweise um näherungsweise eine Scheibendicke weiterbewegt.

Die Rückwand 9 des Scheibenmagazins 2 enthält, vorteilhaft etwa gegenüber der Austrittsöffnung für die Scheiben, und im günstigsten Fall auf ungefähr derselben Höhe, das Vereinzelungsdüsensystem 5, das über eine Absperrmöglichkeit mit der Zuleitung 10 für das Fluid 11 verbunden ist.

Als Fluide werden vorteilhaft Flüssigkeiten eingesetzt, die chemisch die gewünschten, z. B. inerten Eigenschaften bezüglich des Materials der scheibenförmigen Werkstücke besitzen und eine geeignete, niedrige Viskosität zur Einstellung der erforderlichen Strömungsverhältnisse aufweisen. Schon aus Kostengründen gelangen wäßrige Medien, d.h. Wasser und/oder wäßrige Lösungen, die beispielsweise chemische Reagentien und/oder Spül- bzw. Reinigungsmittel enthalten können, mit besonderem Vorteil zum Einsatz. Es ist aber auch die Verwendung anderer Flüssigkeiten, z. B. dünnflüssiger Öle, möglich. Es hat sich auch als vorteilhaft erwiesen, Flüssigkeiten vor der Anwendung zu filtern, um eine Verschmutzung der Düsen und damit zum Beipiel eine Ablenkung oder Streuung des Düsenstrahls zu vermeiden. Die Verwendung von Gasen, etwa Druckluft, oder aus Reinheitsgründen, beispielsweise Inertgasen wie Argon oder Stickstoff, ist im Prinzip zwar auch möglich, scheidet aber dann aus, wenn dünne Scheiben, etwa im Bereich kleiner als 200 »m, vereinzelt werden sollen. Solch dünne Scheiben neigen in der Regel dazu, im Gasstrom zu vibrieren und zerbrechen unabhängig vom Gasdruck, während sie bei der Anwendung von Flüssigkeiten als fluidem Medium überraschenderweise vereinzelt werden können ohne daß derartige Schwingungsphänomene und Beschädigungen auftreten.

Besonderer Bedeutung kommt der Anordnung der das jeweils eingesetzte Fluid in den Innenraum des Scheibenmagazins freigebenden Düsen zu. Die Form und lichte Weite der Düsen richtet sich im wesentlichen nach dem jeweils eingesetzten fluiden Medium und wird zweckmäßig in Vorversuchen auf die gewünschten Vereinzelungsbedingungen hin optimiert. In der Regel haben sich beispielsweise Düsen mit rundem Querschnitt und Durchmessern im Bereich von 0.1 - 5 mm, vorteilhaft 0.5 mm bewährt, wobei die Untergrenze im Regelfall durch die Viskosität der Medien, die Obergrenze letztlich durch die vertretbaren Durchflußmengen und den verfügbaren Druck gegeben ist. Je kleiner der Düsenquerschnitt ist, desto größer ist in der Regel die Schubstärke. Der Fachmann kann damit leicht durch Regulation des Drucks und Einstellung der Düsengröße die Schubstärke auf die zu vereinzelnden Scheiben abstimmen. Für flüssige Medien können mit Betriebsdrücken von bis zu 20 bar, vorteilhaft 0.2 bis 8 bar, insbesondere 4 bar gute Ergebnisse erzielt werden. Solche Drücke lassen sich z. B. durch Pumpen oder bei flüssigen Medien Hochbehälter erreichen.

Anstelle von Düsen mit rundem Querschnitt können auch solche mit ovalem, quadratischem, rechteckigem oder schlitzartigem Querschnitt vorgesehen werden. Allgemein ist es auch möglich, durch die Gestaltung der Auslaßöffnung die Austrittscharakteristik des Mediums zu beeinflussen, um beispielsweise Voll-, Streu- oder Sprühstrahlen oder entsprechende Mischformen vorzusehen.

Die Rückwand des Scheibenmagazins enthält das Düsensystem 5, welches vorzugsweise zwei unterschiedliche Arten von Düsen, Transportdüsen und Vereinzelungsdüsen aufweist. Vorteilhaft ist dabei zumindest eine Vereinzelungsdüse vorgesehen, d.h. eine Düse die im wesentlichen auf die Trennfuge zwischen den beiden obersten Scheiben gerichtet ist. Das von ihr freigegebene Fluid unterwandert die oberste Scheibe und hebt diese gegen die Adhäsionskraft ab, wobei ein Fluidpolster zur nächsten Scheibe entsteht. Vorteilhaft ist es, die Vereinzelungsdüse unter der Oberkante des gegenüberliegenden Wehrs anzuordnen. Dabei hat es sich als insbesondere günstig erwiesen, die Vereinzelungsdüsen in einem Winkel von -20 bis +20° zur Scheibenoberfläche anzuordnen. Es können grundsätzlich beliebig viele Vereinzelungsdüsen, beispielsweise bis zu 50, angebracht werden, vorteilhaft haben sich auch im Hinblick auf den Verbrauch von Fluid 4-20 erwiesen, die günstigerweise im Abstand von etwa 1-2 mm zueinander angeordnet werden.

Über der Reihe der Vereinzelungsdüsen, vorteilhaft mit etwa 5 mm Abstand, befindet sich mindestens eine, vorteilhaft mehrere, insbesondere 2-20 Transportdüsen, die in einem spitzen Winkel auf die Oberfläche der Scheiben gerichtet sind, so daß das ausströmende Fluid diese vorwärts schiebt. Der Winkel der Düse zur Scheibenoberfläche in Verbindung mit dem Druck des Fluids beeinflußt die Geschwindigkeit, mit der die zu vereinzelnde Scheibe das Magazin verläßt. Vorteilhaft sind Winkel im Bereich von 0° bis 30°, insbesondere etwa um 5-15°.

Bei der Vereinzelung verunreinigter Scheiben kann das Fluid bei entsprechender Zusammensetzung, beispielsweise Wasser unter Zusatz von Tensid, neben der Vereinzelung auch zur Spülung und Reinigung der Scheiben dienen. Feste und körnige Bestandteile können somit bereits abgesprüht werden. Vorteilhaft ist es auch, durch Zugabe geeigneter Lösemittel die Verunreinigungen von der Oberfläche der Scheiben wegzulösen.

Die Düsen können beispielsweise konstant mit Fluid beaufschlagt werden. Bevorzugt ist jedoch die taktartige, stoßweise Anwendung von Fluid. Beispielweise kann das Düsensystem immer dann mit Fluid beaufschlagt werden, wenn der Scheibenstapel eine bestimmte Grenzhöhe im Scheibenmagazin überschritten hat. Dies kann mit geeigneten Sensoren, z.B. Lichtschranken, gemessen und gesteuert werden.

Die oberste, zu vereinzelnde Scheibe 4 verläßt das Scheibenmagazin über eine Abstreifkante (Wehr) 8. Dabei handelt es sich bevorzugt um eine Platte, deren Oberkante sich parallel zur unteren Fläche der das Magazin verlassenden Scheibe befindet. Die Platte verhindert, daß mehr als eine Scheibe durch den von der gegenüberliegenden Seite des Magazins ausgeübten Druck des Fluids das Magazin verläßt. Das Wehr kann von der Scheibenform unabhängig eine flache Platte senkrecht zur Stapelrichtung sein, kann jedoch in besonderen Ausführungsformen der Scheibenform angepaßt werden. Bei der oberen Kante des Wehrs, die mit der Unterseite der Scheibe in Berührung kommen kann, wird vorteilhaft durch eine abgerundete und geglättete Ausführung gewährleistet, daß die Scheibenunterseite nicht beschädigt wird. Es hat sich auch als günstig erwiesen, mindestens eine Düse im Wehr so anzuordnen, daß eine Schicht des Fluids die Scheibe beim Verlassen des Magazins vom Wehr trennt.

Die Formgebung von Rückwand 9 und Seitenplatten 7 des Scheibenmagazins ist abhängig von der Ausführungsform der Vorrichtung und der Form der zu vereinzelnden Scheiben. Falls runde oder polygonale Scheiben zu vereinzeln sind, hat es sich als günstig erwiesen, die Rückwand im Querschnitt der Scheibenform anzupassen und entsprechend gewölbt oder eckig auszuführen. Die Seitenplatten dienen zur Führung der Scheiben und können in besonderen Ausführungsformen dann auch leicht trichterförmig aufeinander zulaufen, um ein leichteres Einlaufen der Scheiben über das Wehr zu ermöglichen. Insbesondere haben sich Seitenplatten als vorteilhaft erwiesen, die so ausgeformt werden, daß sich zwischen den Scheiben ein Wasserdruck aufbauen kann, der das Abheben der obersten Scheibe unterstützt. Dies wird insbesondere durch einen geringen Abstand der Seitenplatten von den scheibenförmigen Werkstücken und eine für das Fluid nahezu oder vollständig dichte Bauweise des Scheibenmagazins erreicht, da dann der Wasserdruck erhöht ist.

Werden die Scheibenstapel in einer Scheibenhalterung eingeführt, so wird vorteilhaft eine rechteckige Ausformung des Scheibenmagazins gewählt, da die Scheibenhalterung individuell der jeweiligen Scheibenform angepaßt werden kann. Rückwand und Seitenplatten sind dann bevorzugt ebene Platten, die rechtwinklig zueinander und dem Wehr angeordnet sind. Die gleiche Form der Vorrichtung wird vorzugsweise dann angewendet, wenn rechteckige Scheiben zu vereinzeln sind.

Es hat sich weiterhin als günstig erwiesen, eine Ablauföffnung und Sammelvorrichtung für das eingesetzte Fluid vorzusehen. Insbesondere vorteilhaft ist es, die gesamte Vorrichtung mit einem Auffanggefäß, beispielsweise einer Wanne, zu umgeben, in der die freiwerdende Flüssigkeit gesammelt wird und ablaufen oder abgepumpt werden kann. Es ist weiterhin günstig, feste Bestandteile vor dem Abtrennen der Flüssigkeit herauszufiltern.

Die Vorrichtung, insbesondere das Scheibenmagazin 2, das Wehr 8, das Transportsystem 12, die Prozeßhorde 13, der Stempel 6 und die Seitenplatten 7, wird zweckmäßig aus gegenüber dem jeweiligen fluiden Medien weitgehend inerten Material gefertigt, das auch gegenüber den zu vereinzelnden, transportierenden und einzuhordenden Scheiben nicht kontaminierend wirken kann. Als Scheibenmagazin 2 für die Aufnahme von besonders empfindlichen scheibenförmigen Werkstücken aus Silicium, Germanium, Galliumarsenid oder Indiumphosphid, aber auch von Scheiben aus oxidischem Material wie Gallium-Gadolinium Granat, ferritischem Material, Saphir, Spinell oder Glaswerkstoffen und Quarz haben sich vor allem Kunststoffe bewährt, wobei insbesondere Polymethylmethacrylate ("Plexiglas"), aber beispielsweise auch Polytetrafluorethylen, Polyvinylidendifluorid, Ethylentetrafluorethylen-Copolymer und ähnliche eingesetzt werden können. Vorteilhaft ist die Anwendung von transparenten oder durchsichtigen Materialien, da sie in einfacher Weise die visuelle und/oder mittels optischer Sensoren vorgenommene Überwachung und gegebenenfalls auch Steuerung der Bewegung der Werkstücke oder der Zufuhr bzw. des Abflusses der eingesetzten fluiden Medien gestatten. Bei scheibenförmigen Werkstücken, bei welchen es auf besondere Reinheit ankommt, können diese Bestandteile mit dem Material, aus dem das Werkstück besteht, ausgekleidet werden, insbesondere also bei Siliciumscheiben für die Bauelementeherstellung (wafers), wo als Auskleidungsmaterial hochreines Silicium verwendet werden kann. Wichtig ist auch, daß das ausgewählte Material genügend formstabil ist, um eine präzise und maßhaltige Orientierung der Düsen wie auch eine genaue Oberflächenbearbeitung zu ermöglichen, so daß eine einen einwandfreien Fluß des Fluids gestattende, plane und von Unebenheiten freie Oberfläche des Wehrs und des Bodens des Scheibenmagazins, des Transportsystems und der Prozeßhorde beispielsweise durch Polieren bereitgestellt und unter den Betriebsbedingungen aufrechterhalten werden kann.

In einer bevorzugten Ausführungsform schließt sich an das Wehr 8, über das die Scheibe 4 die Vorrichtung zur Vereinzelung verläßt, eine Vorrichtung 12 zum Transport der Scheibe an. Dabei kann es sich beispielsweise um eine Transportvorrichtung handeln, bei der die Scheibe auf zwei beweglichen Riemen ruhend bewegt wird. Anlagen dieser Art sind dem Fachmann bekannt. Bevorzugt wird jedoch der Transport der Scheibe mit Hilfe fluider Medien, insbesondere Wasser, wie in dem Ausführungsbeispiel, das in Figur 1 dargestellt ist. Dabei wird die Scheibe wiederum durch ein fluides Medium, beispielsweise Wasser, das aus Düsen in der Boden- und Abdeckplatte strömt, über die Transportstrecke bewegt.

Das fluide Medium, das den Transport übernimmt, kann dabei das gleiche wie das in der Vereinzelungsvorrichtung sein. Es kann aber von Vorteil sein, unterschiedliche fluide Medien zu verwenden, zum Beispiel dann, wenn während des Transportvorgangs bereits ein Reinigungsprozeß mit den scheibenförmigen Werkstücken vorgenommen werden soll, insbesondere dann, wenn die Scheiben direkt nach einem Sägeprozeß vereinzelt und transportiert werden und noch mit prozeßbedingten Verunreinigungen wie Sägestaub und -mittel behaftet sind. In diesem Fall können die Düsen beispielsweise mit einer Lösung beaufschlagt werden, der Additive wie beispielsweise Tenside oder Komplexbildner zugesetzt sind. In einer anderen Ausführungsform können statt Flüssigkeiten Gase, die auch aufgeheizt sein können, als fluides Medium verwendet werden, um während des Transports gleichzeitig eine Trocknung feuchter Scheiben zu erreichen.

Das Ende der Transportvorrichtung enthält vorzugsweise Düsen, die zum Abbremsen der scheibenförmigen Werkstücke dienen, um einen sanften, materialschonenden Übergang der Scheiben aus der Transportvorrichtung in die darauf folgende Übernahmevorrichtung, z. B. eine Einhordvorrichtung, zu ermöglichen. Die Sprühwirkung der Bremsdüsen muß dabei der Transportrichtung entgegengerichtet sein. Das Ausmaß des Bremseffektes aufgrund von Druck und Düsengröße kann vom Fachmann in entsprechenden Vorversuchen ermittelt werden.

In der in der Figur dargestellten bevorzugten Ausführungsform werden die Scheiben 4 aus der Transportvorrichtung 12 in eine Einhordvorrichtung 13 übergeben. Die Einhordvorrichtung 13 besteht aus einer Prozeßhorde 14 mit Vorschubeinheit 15. Die mit den scheibenförmigen Werkstücken gefüllten Prozeßhorden können dann beispielsweise entnommen und direkt als Einsätze für Reinigungs- oder Ätzbäder verwendet werden. Die Prozeßhorde 14 kann aber auch aus einer Horde bestehen, in der die Scheiben beispielsweise bereits zum Versand aufbewahrt werden. Die Vorschubeinheit kann von Hand betrieben werden. Bevorzugt ist wieder der Einsatz einer mechanischen Vorschubhilfe, beispielsweise eines Elektromotors, zum Beispiel ein Gleichstrom- oder Schrittmotor. Die Vorschubeinrichtung kann beispielsweise durch einen Sensor, insbesondere einen optischen Sensor, gesteuert werden, der das Verlassen einer Scheibe aus dem Scheibenmagazin mißt und der beispielsweise auch mit dem Taktgeber für das Fluid gekoppelt wird, so daß auch eine selektive Steuerung von Vorschub- und Bremsdüsen möglich ist.

Es hat sich gezeigt, daß auf diese Art und Weise direkt nach der Vereinzelung der scheibenförmigen Werkstücke aus einem Scheibenstapel eine ganze Behandlungsstraße aufgebaut werden kann, in denen die Scheiben nacheinander mit wechselnden Fluiden beschickte Vorrichtungen durchlaufen und somit hintereinander beispielsweise geätzt, gespült, gereinigt, getrocknet oder anderen naßchemischen Verfahren unterworfen werden können.

Die Erfindung hat den Vorteil, daß das zeitraubende und manuelles Geschick erfordernde Vereinzeln dünner Scheiben von Hand nicht mehr erforderlich ist. Damit wird eine unattraktive und monotone Arbeit vermieden. Der Materialverbrauch durch Bruch und Beschädigung von Scheiben kann stark reduziert werden. Insbesondere bei sehr dünnen Scheiben ist die Gefahr von Beschädigungen stark gemindert. Es hat sich auch gezeigt, daß speziell durch das Vereinzeln im Wasserstrahl weniger Scheiben zerbrechen, als wenn der Vorgang von Hand ausgeführt wird. Durch die Möglichkeit der gleichzeitigen Reinigung und anderer Bearbeitungsschritte bei einer Kombination des Vereinzelungsverfahrens mit dem Transport- und Einhordungsverfahren können weitere Arbeitsgänge gespart werden. Das Problem der Kontamination kann durch den Einsatz dieses Verfahrens fast völlig ausgeschlossen werden, da das Material der scheibenförmigen Werkstücke zu keinem Zeitpunkt mit Fremdkörpern in Berührung kommt. Selbst beim Übergang über das Wehr ist die Scheibe durch eine dünne Schicht von Fluid noch vom Material des Wehrs getrennt, so daß Kontamination und Beschädigung ausgeschlossen werden kann. Ein weiterer Vorteil ist die leichte Kombinierbarkeit der Erfindung mit Vorrichtungen für folgende Prozeßschritte, was den Aufbau von Zeit und Arbeitskraft sparenden Behandlungsstraßen ermöglicht.

## Patentansprüche

1. Vorrichtung zum Vereinzeln von scheibenförmigen Werkstücken, insbesondere Halbleiterscheiben, von einem Scheibenstapel, mit
a) einem Scheibenmagazin (2) zur Aufnahme eines Scheibenstapels (1), in dem benachbarte Scheiben berührend aufeinanderliegen, mit einer Vorschubeinheit (3), die die oberste Scheibe (4) des Scheibenstapels in den Wirkungsbereich eines fluiden Mediums (11) bringt,
b) einem Düsensystem (5), durch das das fluide Medium in einer Vorzugsrichtung unter Druck austritt,
c) einem Wehr (8), das es erlaubt, genau eine Scheibe aus dem Scheibenstapel (1) zu vereinzeln.

2. Vorrichtung nach Anspruch 1, dadurch gekennzeichnet, daß die Vorzugsrichtung des Düsenaustritts zum Teil auf die Trennfuge zwischen den Scheiben gerichtet ist.

3. Vorrichtung nach Anspruch 1 oder 2, dadurch gekennzeichnet, daß die Vorschubvorrichtung (3) getaktet ist.

4. Vorrichtung nach einem oder mehreren der Ansprüche 1 bis 3, gekennzeichnet dadurch, daß der Austritt des fluiden Mediums aus dem Düsensystem getaktet erfolgt.

5. Vorrichtung nach einem oder mehreren der Ansprüche 1 bis 4, gekennzeichnet dadurch, daß Seitenplatten die zu vereinzelnden scheibenförmigen Werkstücke führen und den Aufbau von Druck zum Abheben der obersten Scheibe unterstützt

6. Vorrichtung nach einem oder mehreren der Ansprüche 1-5, dadurch gekennzeichnet, daß zur Aufnahme der vereinzelten scheibenförmigen Werkstücke mindestens ein Transportsystem (12) dient.

7. Vorrichtung nach Anspruch 6, dadurch gekennzeichnet, daß im Transportsystem (12) der Transport durch ein aus einem Düsensystem strömendes fluides Medium erfolgt.

8. Vorrichtung nach einem oder mehreren der Ansprüche 1 bis 7, dadurch gekennzeichnet, daß als fluides Medium ein wäßriges Medium dient.

9. Vorrichtung nach einem oder mehreren der Ansprüche 6-8, dadurch gekennzeichnet, daß an die Vorrichtung zum Vereinzeln oder zum Vereinzeln und dem Transport scheibenförmiger Werkstücke eine Vorrichtung zum Einhorden scheibenförmiger Werkstücke (13) angeschlossen ist.

10. Vorrichtung nach Anspruch 9, gekennzeichnet dadurch, daß der Vorschub der Vorrichtung zum Einhorden scheibenförmiger Werkstücke durch einen Sensor gesteuert wird.

11. Vorrichtung nach Anspruch 9 oder 10, dadurch gekennzeichnet, daß zumindest beim Einsortieren der Scheiben in die Prozeßhorde (14) ein Abbremsen der Scheiben durch Bremsdüsen erfolgt.

12. Verfahren zum Vereinzeln von scheibenförmigen Werkstücken, insbesondere Halbleiterscheiben, aus einem Scheibenstoß, gekennzeichnet dadurch, daß eine Vorrichtung aus einem oder mehreren der Ansprüche 1-5 und 8 verwendet wird und von einem in einem Scheibenmagazin (2) befindlichem Stapel von scheibenförmigen Werkstücken, in dem benachbarte Scheiben berührend aufeinanderliegen, einzelne Scheiben durch Einwirkung eines aus Düsen strömenden fluiden Mediums entnommen werden.

13. Verfahren zur Vereinzelung und dem Transport scheibenförmiger Werkstücke, dadurch gekennzeichnet, daß eine der Vorrichtungen nach Anspruch 6-8 verwendet wird und nach der Vereinzelung der scheibenförmigen Werkstücke mindestens ein Transportvorgang erfolgt, wobei für Vereinzelung und Transport unterschiedliche fluide Medien eingesetzt werden können.

14. Verfahren zur Vereinzelung, dem Transport und der Einhordung scheibenförmiger Werkstücke, dadurch gekennzeichnet, daß eine der Vorrichtungen nach Anspruch 9-11 verwendet wird, nach der Vereinzelung der scheibenförmigen Werkstücke mindestens ein Transportvorgang erfolgt und die derartig vereinzelten und transportierten Scheiben in eine mit einer Vorschubeinheit (15) versehene Prozeßhorde (14) einsortiert werden, wobei für Vereinzelung, jeden Transportschritt und die Einhordung unterschiedliche fluide Medien eingesetzt werden können.

## Claims

1. Apparatus for separating disc-type workpieces, in particular semiconductor wafers, from a wafer stack, comprising
a) a wafer magazine (2) for receiving a wafer stack (1), in which adjacent wafers lie in contact one on top of the other, having a feed unit (3) which brings the uppermost wafer (4) of the wafer stack into the sphere of action of a fluid medium (11),
b) a nozzle system (5) through which the fluid medium emerges under pressure in a preferred direction, and
c) a dam (8) which makes it possible to separate precisely one wafer from the wafer stack (1).

2. Apparatus according to in Claim 1, characterized in that the preferred direction of the nozzle outlet is directed in part at the parting line between the wafers.

3. Apparatus according to Claim 1 or 2, characterized in that the feed apparatus (3) is indexed.

4. Apparatus according to one or more of Claims 1 to 3, characterized in that the emergence of the fluid medium from the nozzle system takes place in a cyclic manner.

5. Apparatus according to one or more of Claims 1 to 4, characterized in that side plates guide the disc-type workpieces to be separated and assist the build-up of pressure for lifting off the uppermost wafer.

6. Apparatus according to one or more of Claims 1 - 5, characterized in that at least one conveying system (12) serves to receive the separated disc-type workpieces.

7. Apparatus according to Claim 6, characterized in that the conveyance in the conveying system (12) is carried out by a fluid medium flowing out of a nozzle system.

8. Apparatus according to one or more of Claims 1 to 7, characterized in that an aqueous medium serves as the fluid medium.

9. Apparatus according to one or more of Claims 6 - 8, characterized in that an apparatus for filling the disc-type workpieces (13) into trays adjoins the apparatus for separating, or for separating and conveying, disc-type workpieces.

10. Apparatus according to Claim 9, characterized in that the feed of the apparatus for filling the disc-type workpieces into trays is controlled by a sensor.

11. Apparatus according to Claim 9 or 10, characterized in that the wafers are decelerated by decelerating nozzles at least during filling of the wafers into the processing tray (14).

12. Method for separating disc-type workpieces, in particular semiconductor wafers, from a stack of wafers, characterized in that an apparatus from one or more of Claims 1 - 5 and 8 is used and individual wafers are removed from a stack of disc-type workpieces, which is located in a wafer magazine (2) and in which adjacent wafers lie in contact one on top of the other by exposure to a fluid medium flowing out of nozzles.

13. Method for separating and conveying disc-type workpieces, characterized in that one of the apparatuses according to Claims 6 - 8 is used and at least one conveying operation takes place after separating the disc-type workpieces, it being possible to use different fluid media for separation and conveyance.

14. Method for separating, conveying and filling disc-type workpieces into trays, characterized in that one of the apparatuses according to Claims 9 - 11 is used, at least one conveying operation being carried out after separating the disc-type workpieces and the wafers separated and conveyed in such a manner are filled into a processing tray (14) provided with a feed unit (15), it being possible to use different fluid media for separation, each conveying step and the tray filling.

## Revendications

1. Installation pour isoler des pièces usinées sous forme de disque, plus particulièrement des disques de semiconducteurs, d'une pile de disques à l'aide
a) d'un magasin (2) de disques pour loger une pile de disques (1), dans lequel les disques voisins se trouvent au contact empilés l'un sur l'autre, avec un dispositif d'avancée (3) qui amène le disque supérieur (4) de la pile de disques dans la zone d'action d'un milieu fluide (11),
b) d'un système de tuyères (5) à travers lequel sort le milieu fluide sous pression dans une direction préférentielle,
c) d'un barrage mobile (8) qui permet d'isoler exactement un disque de la pile des disques (1).

2. Dispositif selon la revendication 1, caractérisé en ce que la direction privilégiée de la sortie de la tuyère est orientée en partie vers la fente de séparation entre les disques.

3. Dispositif selon la revendication 1 ou 2, caractérisé en ce que le dispositif d'avancée (3) est synchronisé.

4. Dispositif selon une ou plusieurs des revendications 1 à 3, caractérisé en ce que la sortie du milieu fluide du système de tuyères est synchronisée.

5. Dispositif selon une ou plusieurs des revendications 1 à 4, caractérisé en ce que les parois latérales conduisent les pièces usinées sous forme de dique à isoler et favorisent la constitution de la pression pour l'enlèvement du disque supérieur.

6. Dispositif selon une ou plusieurs des revendications 1 à 5, caractérisé en ce que pour la réception des pièces usinées sous forme de disque isolées, on utilise au moins un système de transport (12).

7. Dispositif selon la revendication 6, caractérisé en ce que dans le système de transport (12) le transport est effectué à l'aide d'un milieu fluide s'écoulant d'un système de tuyères.

8. Dispositif selon une ou plusieurs des revendications 1 à 7, caractérisé en ce qu'on utilise en tant que milieu fluide un milieu aqueux.

9. Dispositif selon une ou plusieurs des revendications 6 à 8, caractérisé en ce que au dispositif pour isoler ou pour isoler et transporter les pièces usinées sous forme de disque est relié un dispositif pour empiler ("Einhorden") les pièces usinées sous forme de disque (13).

10. Dispositif selon la revendication 9, caractérisé en ce que l'avancement du dispositif pour empiler les pièces usinées sous forme de disque est contrôlé per un capteur.

11. Dispositif selon la revendication 9 ou 10, caractérisé en ce qu'au moins lors du rangement des disques dans le récipient d'opération (14) ("Prozesshorde") on effectue un freinage des disques à l'aide de gicleurs à réaction.

12. Procédé pour l'isolement de pièces usinées sous forme de disque, notamment des disques de semiconducteurs, comprend une pile de disques, caractérisé en ce qu'on utilise un dispositif selon une ou plusieurs des revendications 1 à 5 et 8 et qu'on prélève d'une pile de pièces usinées sous forme de disque, se trouvant dans un magasin de disques (2), dans laquelle les disques voisins sont disposés en contact étroit, des disques individuels sous l'effet d'un milieu fluide s'écoulant des tuyères.

13. Procédé pour l'isolement et le transport de pièces usinées sous forme de disque, caractérisé en ce qu'on utilise l'un des dispositifs selon les revendications 6 à 8 et après l'isolement des pièces usinées sous forme de disque, on effectue au moins un processus de transport, en pouvant utiliser pour l'isolement et le transport différents milieux fluides.

14. Procédé pour l'isolement, le transport et l'empilement des pièces usinées sous forme de disque, caractérisé en ce qu'on utilise l'un des dispositifs selon les revendications 9 à 11, après l'isolement des pièces usinées sous forme de disque on effectue au moins une opération de transport et les disques ainsi isolés et transportés sont rangés dans un récipient d'opération (14) équipé d'une unité d'avancée (15), en pouvant utiliser pour l'isolement, pour chaque étape de transport et l'empilement différents milieux fluides.
